Europäisches Patentamt

European Patent Office

Office européen des brevets

(19)

(11) Veröffentlichungsnummer : **0 290 917 B1**

(12) **EUROPÄISCHE PATENTSCHRIFT**

(45) Veröffentlichungstag der Patentschrift :
**21.09.94 Patentblatt 94/38**

(51) Int. Cl.⁵ : **G03F 7/32**

(21) Anmeldenummer : **88107061.9**

(22) Anmeldetag : **03.05.88**

(54) **Verfahren zum Entwickeln von wasserlos druckenden Offsetplatten.**

(30) Priorität : **12.05.87 DE 3715792**

(43) Veröffentlichungstag der Anmeldung :
**17.11.88 Patentblatt 88/46**

(45) Bekanntmachung des Hinweises auf die
Patenterteilung :
**21.09.94 Patentblatt 94/38**

(84) Benannte Vertragsstaaten :
**DE GB**

(56) Entgegenhaltungen :
**EP-A- 0 043 132**
**DE-A- 1 900 468**
**DE-A- 3 543 961**

(56) Entgegenhaltungen :
**PATENT ABSTRACTS OF JAPAN, Band 8, Nr.**
**278 (P-322)[1715], 19. Dezember 1984; & JP-**
**A-59 146 054**
**PATENT ABSTRACTS OF JAPAN, Band 9, Nr.**
**151 (P-367)[1874], 26. Juni 1985; & JP-A-60 28**
**655**

(73) Patentinhaber : **HOECHST**
**AKTIENGESELLSCHAFT**
**D-65926 Frankfurt (DE)**

(72) Erfinder : **Schlosser, Hans-Joachim, Dr.,**
**Dipl.-Chem.**
**Am Rosengarten 2a**
**D-6200 Wiesbaden (DE)**
Erfinder : **Strack, Jörg**
**Rheinstrasse 12**
**D-5429 Mittelfischbach (DE)**

EP 0 290 917 B1

## Beschreibung

Die Erfindung betrifft ein Verfahren zur Entwicklung positiv arbeitender, wasserlos druckender Offsetplatten. Insbesondere ist das Verfahren zum Entwickeln von lichtempfindlichen Druckplatten geeignet, die aus einem Schichtträger, einer lichtempfindlichen, ein Diazoniumsalz-Polykondensationsprodukt enthaltenden Schicht und einer darüberliegenden, Druckfarbe abstoßenden vernetzten Silikonkautschukschicht bestehen, wobei das Diazoniumsalz-Polykondensationsprodukt aus wiederkehrenden Einheiten A-$N_2$X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

Solche Platten sind in der nicht vorveröffentlichten deutschen patentanmeldung P 35 45 204.8 beschrieben, wobei die lichtempfindliche Schicht Diazoniumsalzkondensationsprodukte nach den US-A 3 867 147 und 3 849 392 enthält und darüber vernetzten Silikonkautschuk. Die Lehre dieser Patentanmeldung (im Folgenden mit A) bezeichnet) soll ausdrücklich auch Gegenstand der vorliegenden Erfindung sein.

Bei solchen oder ähnlich aufgebauten Platten vernetzt die lichtempfindliche Schicht an den belichteten Stellen und ist dann im Entwickler nicht löslich. Bei der Entwicklung sind Silikonkautschuk und lichtempfindliche Schicht nicht abreibbar. An den nicht belichteten Stellen bleibt die lichtempfindliche Schicht löslich, und mit dem Entwickler werden Silikongummi und lichtempfindliche Schicht abgerieben und der Träger oder die haftvermittelnde Schicht auf dem Träger werden freigelegt. Wird nun eine so behandelte Platte in eine Druckmaschine eingespannt und eingefärbt, so geht die Farbe an die freigelegten Stellen; an den silikonbedeckten Stellen wird die Farbe abgestoßen. Es ist ein Drucken ohne Feuchtwasser möglich.

Der Entwickler hat bei solchen Platten die Aufgabe, durch den Silikongummi zu diffundieren und die lichtempfindliche Schicht an den nicht belichteten Stellen auf zulösen und ein Abreiben des Silikongummis an diesen Stellen zu ermöglichen. Außerdem muß er den Silikongummi anquellen und den abgeriebenen Gummi dispergieren, um Fladenbildung zu vermeiden. Nur so ist es möglich, eine gute Auflösung zu erzielen.

Entwickler für wasserlos druckende Platten sind beispielsweise in der US-A 3 677 178 beschrieben. Hier wird die Entwicklung mit Wasser, dem kleine Mengen Benetzungsagentien, wie Na-laurylsulfonate, Alkylphenylether, Polyethylenglykol, Trimethylnonylether von Propylenglykol und Polyalkylglykolether zugesetzt sind, vorgeschlagen. Mit dieser Entwicklerzusammensetzung ist eine Entwicklung von Platten, wie sie insbesondere nach A) aufgebaut sind, nicht möglich.

In der DE-B 16 71 637 (= US-A 3 511 178) wird als Entwickler für wasserlos druckende Offsetplatten eine Mischung aus Butylacetat, Propylalkohol und Wasser beschrieben. Abgesehen davon, daß eine Mischung dieser Art sich durch unterschiedliche Verdunstungsgeschwindigkeiten schnell verändert, sind keine ausreichenden Auflösungen zu erzielen (Vergleichsbeispiel V1). Auch das in dieser Anmeldung genannte Butyrolacton führt, insbesonders bei Platten nach A), zu unzureichender Entwicklung (Vergleichsbeispiel V2).

In der US-A 3 894 873 werden zur Entwicklung paraffinische Kohlenwasserstoffe, Benzol, Toluol, Xylol u. a. benutzt. Dazu können bevorzugt weniger als 50 % halogenierte Kohlenwasserstoffe, Alkohole, Ketone, Carbonsäuren oder Ester zugesetzt werden. Es handelt sich hier allerdings um die Entwicklung von Platten, die als lichtempfindliche Schicht Photopolymere, die eine Vernetzung mit der Silikongummigrenzfläche bewirken, enthalten, wobei diese Schicht auch im unbelichteten Zustand nicht angegriffen werden darf. Eine Entwicklung mit reinen isoparaffinischen Kohlenwasserstoffen ist bei den Platten - z. B. nach A) - auch wegen des anderen Wirkungsprinzips nicht möglich (Vergleichsbeispiel V3).

Ebenso wird in der EP-A 0 043 132 (= US-A 4 378 423) ein Entwickler für die Photoadhäsivschichten beschrieben, der die lichtempfindliche Schicht nicht angreifen darf. Er enthält überwiegend paraffinische Kohlenwasserstoffe, denen erfindungsgemäß Propylenglykolderivate von 2 bis 20 % zugesetzt werden. Zugesetzt werden können dazu Lösungsmittel wie Wasser, Alkohole, Ester, Ether, Carbonsäuren, aromatische Kohlenwasserstoffe sowie halogenierte Kohlenwasserstoffe in einer Menge, daß auch die nicht gehärtete Photoadhäsivschicht nicht angegriffen wird. Entwickler dieser Lehre sind wegen des anderen Prinzips - z. B. von A) (Entwicklung und Auflösung der lichtempfindlichen Schicht) - unzureichend (Vergleichsbeispiel V4).

In der DE-A 35 43 961 wird für wasserlose Offsetdruckplatten ein Entwickler beschrieben, der aus mindestens zwei organischen Lösungsmitteln, einem oberflächenaktiven Mittel und mindestens 30 % Wasser besteht. Dieser Entwickler ist für Platten geeignet, die als lichtempfindliche, photohärtende Schicht ungesättigte Monomere, lichtempfindliche Polymere, Azidoharze oder Zinksalzkomplexe eines Kondensats von Formaldehyd und Diazoniumverbindung enthalten. Ein Lösungsmittel soll die lichtempfindliche Schicht in den nicht belichteten Bereichen auflösen, das zweite soll den Silikongummi quellen. Als quellendes Lösungsmittel werden

2

EP 0 290 917 B1

genannt: Alkohole, Ester, Ketone, Ether, aromatische Kohlenwasserstoffe, halogenierte Kohlenwasserstoffe und Carbonsäuren. Als zweites Lösungsmittel werden beansprucht: Paraffinkohlenwasserstoffe, Cycloparaffinkohlenwasserstoffe, aromatische Kohlenwasserstoffe, aliphatische Ketone, Glykolether und Alkylester aliphatischer Carbonsäuren. Verwendet man einen Entwickler dieser Art mit mindestens 30 % Wasser für die Entwicklung einer Schicht, z. B. nach A), so erhält man eine unzureichende Auflösung bei der Wiedergabe feiner Raster (Vergleichsbeispiel V5).

Aufgabe der vorliegenden Erfindung ist es deshalb, ein Verfahren zum Entwickeln von wasserlos druckenden Offsetplatten, die auf einem Schichtträger eine lichtempfindliche Schicht aus einem Diazoniumsalz-Polykondensationsprodukt und eine darüberliegende, Druckfarbe abstoßende, vernetzte Silikonkautschukschicht aufweisen, insbesondere solche nach A), bereitzustellen, das in kurzer Zeit eine gute Auflösung ergibt, wobei der Entwickler mit Wasser mischbar ist und einen genügend hohen Flammpunkt besitzt, so daß er auch ohne weiteres für den Einsatz in modernen Entwicklungsmaschinen geeignet ist.

Gelöst wird die vorstehend genannte Aufgabe durch ein Verfahren, das dadurch gekennzeichnet ist, daß der Entwickler überwiegend Verbindungen der allgemeinen Formel $R-(O-CH_2-CH_2-)_n-O-R$ enthält, wobei R = $C_mH_{2m+1}$, n = eine Zahl von 1 bis 25 und m = eine Zahl von 1 bis 5 bedeuten und der Wassergehalt in dem Entwickler maximal 20 Gew.-% beträgt. Als Verbindungen der allgemeinen Formel sind vorzugsweise Glykoldiether geeignet. Besonders bevorzugt sind beispielsweise Diethylenglykoldimethylether (DDM), Polyethylenglykoldimethylether (PDM), Diethylenglykoldibutylether (DDB), Diethylenglykoldiethylether (DDE), Triethylenglykoldimethylether (TDM). Diese Verbindungen können alleine oder aber auch in Mischungen miteinander verwendet werden.

Entwickler auf dieser Basis können noch zur besseren Benetzung des Silikonkautschuks und besseren Dispergierung des abgeriebenen Silikongummis Zusätze enthalten. Diese Zusätze sind beispielsweise Tenside. Als Tenside können anionische, kationische und nichtionische Typen verwendet werden. Vom anionischen Typ kommen beispielsweise aliphatische Säuresalze, Sulfosuccinamate, Acylaminoalkansulfonate, Sarkoside, Alkylphosphate, Alkylethersulfate, Alkylaryletherphosphate, Alkyletherphosphate und Alkylethercarboxylate in Betracht. Kationaktive Tenside sind beispielsweise geradkettige Alkylammoniumverbindungen, cyclische Alkylammonium-, Pyridinium-, Chinolinium-, Pyrrolidinium- und Piperidiniumverbindungen. Nichtionische Tenside sind beispielsweise Polyglykolether, Alkylpolyglykolether, Arylalkylpolyglykolether, Acylpolyglykolether, Acylamidpolyglykolether, Alkylaminopolyglykoletherpropylenoxidaddukte, Polyolester, Fettsäurealkanolamide, Polyglykole und Polypropylenglykole. Auch Ampholyte und Fluortenside sind einsetzbar.

Zusätze wie Alkohole, bevorzugt 5 bis 40 %, insbesondere Glykole, und Wasser sind möglich, wobei der Wassergehalt unter 20 % liegen sollte wegen einer deutlichen Verschlechterung der Auflösung. Als Zusatz zur besseren Benetzung des Silikonkautschuks sind auch aliphatische und aromatische Kohlenwasserstoffe geeignet. Die Zusätze sollen die Menge von Verbindung 1 nicht überschreiten. Als Zusätze zur Entwicklungsbeschleunigung sind auch Stoffe wie N,N-Dimethylformamid, Dimethylsulfoxid, Butyrolacton, N-Methylpyrrolidon, N,N-Methylacetamid und N-Hexylpyrrolidon gut geeignet.

Die Erfindung wird in der Tabelle anhand von Beispielen erläutert, ohne daß jedoch eine Einschränkung hierauf bestehen soll. Für die Entwicklung werden folgende Platten verwendet:

Platte I

3 Gewichtsteile (Gt) eines Kondensationsprodukts aus 1 mol 3-Methoxydiphenylamin-4-diazoniumsalz und 1 mol 4,4'-Bis-methoxymethyldiphenylether, isoliert als Mesitylensulfonat, und 3 Gt eines Umsetzungsproduktes aus 50 Gt Polyvinylbutyral mit 4 Gt Maleinsäureanhydrid wurden in 93,61 Gt 2-Methoxyethanol gelöst. Zu der Lösung wurden 0,3 Gt Phthalocyanin und 0,02 Gt Phenylazodiphenylendiamin und 0,07 Gt Phosphorsäure gegeben. Die Lösung wurde auf eine elektrolytisch aufgerauhte und anodisch oxidierte Aluminiumplatte aufgebracht. Das Schichtgewicht betrug 1 g/m$^2$.

Eine Lösung von 5 Gt eines Dimethylpolysiloxans mit endständigen, an Silicium gebundenen OH-Gruppen, das eine Plastizität nach Brabender von 5,8 kNm aufweist, und 0,3 Gt einer Lösung eines Methylhydrogenpolysiloxans mit endständigen Trimethylsiloxygruppen mit einer Viskosität von 0,4 cm$^2$/s bei 25 °C in 9,7 Gt Toluol wurde mit 84 Gt einer 50%igen Lösung des Umsetzungsprodukts aus 1,99 Gt eines Dimethylpolysiloxans mit endständigen OH-Gruppen (OH-Gruppengehalt 3,5 %) und 1 Gt 3-(2-Aminoethylamino)propyltrimethoxysilan versetzt. 0,4 Gt eines Gemisches aus Vinyltrimethoxysilan und 3-Glycidyloxypropyltrimethoxysilan wurden zugesetzt. Diese Silikonkautschukschicht wurde auf die lichtempfindliche Schicht zu einem Schichtgewicht von 3,4 g/m$^2$ nach drei Minuten Trocknen bei 110 °C aufgebracht.

3

Platte II

3 Gt Diazoniumsalz und 3 Gt Binder gemäß Platte I wurden in 93,9 Gt 2-Methoxyethanol gelöst. Diese Lösung wurde auf eine elektrolytisch aufgerauhte und anodisch oxidierte Aluminiumplatte aufgebracht. Das Schichtgewicht betrug 1 g/m².

10 Gt eines Dimethylpolysiloxans mit endständigen Vinyldimethylsiloxaneinheiten mit einer Viskosität von 400 mPa·s bei 25 °C wurden mit 0,025 Gt 2-Methyl-3-butin-2-ol, 0,3 Gt der unten beschriebenen Mischung aus Platinkomplex von Vinylsiloxan als Katalysator und Verdünnungsmittel, 0,09 Gt eines Mischpolymerisats aus 4 mol-% Trimethylsiloxan-, 72 mol-% Methylhydrogensiloxan- und 24 mol-% Dimethylsiloxaneinheiten mit einer Viskosität von 50 mPa·s bei 25 °C und einem Gehalt von 1,36 % an Si gebundenen Wasserstoffs und 88,9 Gt (R)Isopar E vermischt. Diese Silikonkautschuklösung wurde auf die lichtempfindliche Schicht aufgebracht. Das Schichtgewicht des Silikongummis betrug 3,4 g/m² nach drei Minuten Trocknen bei 110 °C.

Die Platinkomplex-Mischung wurde wie folgt hergestellt: Zu einer Mischung aus 10 Gt $H_2PtCl_6 \cdot 6H_2O$, 20 Gt 1,3-Divinyl-1,1,3,3-tetramethyldisiloxan und 50 Gt Ethanol wurden 20 Gt Natriumhydrogencarbonat gegeben. Das Gemisch wurde 30 Minuten unter Rührem zum Sieden unter Rückfluß erhitzt, dann 15 Stunden stehengelassen und danach filtriert. Aus dem Filtrat wurden bei 16 mbar die flüchtigen Bestandteile abdestilliert. Als Rückstand wurden 17 Gt einer Flüssigkeit erhalten, die in Benzol gelöst wurde. Die Lösung wurde filtriert und aus dem Filtrat das Benzol abdestilliert. Der Rückstand wurde mit einem Dimethylpolysiloxan, das endständige Vinyldimethylsiloxaneinheiten hatte und eine Viskosität von 1,4 Pa·s bei 23 °C aufwies, als Verdünnungsmittel in solcher Menge vermischt, daß das Gemisch 1 Gew.-% Platin, berechnet als Element, enthielt.

Die Platten I und II wurden nach mindestens 24 Stunden Lagerung 70 Sekunden mit einer 5-kW-Metallhalogenidlampe unter einer Vorlage belichtet. Die belichteten Platten wurden mit den in der Tabelle angegebenen Entwicklerlösungen 6 Minuten mit einem oszillierenden Filz (Hub 4,8 mm, Oszillationsfrequenz 3000/min, Andruck 1500 N/m²) behandelt. Anschließend wurde die Platte mit Wasser gespült, getrocknet und mit Druckerschwärze eingefärbt. Die erzielte Auflösung wurde mit einem UGRA-Offset-Testkeil 1982 in den negativen und positiven Spitzpunktfeldern (60 l/cm) beurteilt.

Tabelle

| Beispiele | Lösungsmittel und Verhältnisse | Auflösung Platte I | | Platte II | |
|---|---|---|---|---|---|
| V1 | Ethylacetat : Propanol : Wasser 2:5:1 | 50 | 98 | 50 | 98 |
| V2 | Butyrolacton | 20 | 96 | 5 | 95 |
| V3 | (R)Isopar (isoparaffin. Kohlenwasserstoffe mit einem Siedebereich von 176 bis 188 °C | keine Entwicklung | | | |
| V4 | (R)Isopar + Tripropylenglykol | keine Entwicklung | | 10 | 99 |
| V5 | (R)Isopar G : Benzylalkohol : i-Octanol : anionakt. Tensid (28 % Lösung in Wasser) 5,25:5,25:2,1:17,5 | 5 | 98 | 40 | 98 |
| 1 | Diethylenglykoldimethylether (DDM) | 2 | 97 | 3 | 98 |
| 2 | Polyethylenglykoldimethylether (PDM 250) | 2 | 97 | 4 | 98 |
| 3 | DDM : Diethylenglykoldibutylether (DDB) : Tripropylenglykol 70:20:10 | 3 | 99 | 3 | 98 |
| 4 | DDM : Diethylenglykoldiethylether (DDE) : PDM 250, 70:20:10 | 2 | 97 | 3 | 99 |
| 5 | Triethylenglykoldimethylether (TDM) : DDE : PDM 250 : N-Methylpyrrolidon 63,6:18,2:9,1:9,1 | 2 | 98 | 2 | 97 |
| 6 | DDM : DDB : PDM 250 : (R)Genamin 050 63,6:18,2:9,1:9,1 | 4 | 98 | 2 | 99 |
| 7 | DDM : (R)Isopar H 70:30 | 2 | 97 | 2 | 99 |

## Patentansprüche

1. Verfahren zum Entwickeln von wasserlos druckenden Offsetplatten, die auf einem Schichtträger eine lichtempfindliche Schicht aus einem Diazoniumsalz-Polykondensationsprodukt und eine darüberliegende, Druckfarbe abstoßende, vernetzte Silikonkautschukschicht tragen, dadurch gekennzeichnet, daß der Entwickler überwiegend Verbindungen der allgemeinen Formel

$$R\text{-}(O\text{-}CH_2\text{-}CH_2\text{-})_n\text{-}O\text{-}R$$

enthält, wobei
$R = C_mH_{2m+1}$,
$n$ = eine Zahl von 1 bis 25 und
$m$ = eine Zahl von 1 bis 5
bedeuten, und der Wassergehalt in dem Entwickler maximal 20 Gew.-% beträgt.

2. Verfahren nach Anspruch 1, dadurch gekennzeichnet, daß das Diazoniumsalz-Polykondensationsprodukt aus wiederkehrenden Einheiten $A\text{-}N_2X$ und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

3. Verfahren nach Anspruch 1 oder 2, dadurch gekennzeichnet, daß der Entwickler aus Mischungen der Verbindungen nach der allgemeinen Formel besteht.

4. Verfahren nach einem der Ansprüche 1 bis 3, dadurch gekennzeichnet, daß der Entwickler zusätzlich Tenside enthält.

5. Verfahren nach Anspruch 4, dadurch gekennzeichnet, daß der Zusatz maximal 15 Gew.-% beträgt.

6. Verfahren nach einem der Ansprüche 1 bis 5, dadurch gekennzeichnet, daß der Entwickler zusätzlich Alkohole enthält.

7. Verfahren nach Anspruch 6, dadurch gekennzeichnet, daß der Zusatz maximal 5 bis 40 Gew.-% beträgt.

8. Verfahren nach einem der Ansprüche 1 bis 7, dadurch gekennzeichnet, daß der Entwickler zusätzlich N,N-Dimethylacetamid, N-Methylpyrrolidon, N-Hexylpyrrolidon, N,N-Dimethylformamid, Dimethylsulfoxid, Butyrolacton oder aliphatische Kohlenwasserstoffe enthält.

9. Verfahren nach Anspruch 8, dadurch gekennzeichnet, daß der Anteil maximal 50 Gew.-% beträgt.

## Claims

1. A process for developing printing plates employing waterless offset processes, which plates are comprised of a support coated with a photosensitive layer comprising a diazonium salt polycondensation product and of a super-imposed ink-repellent, crosslinked silicone elastomer layer, characterized in that the developer contains a predominant proportion of compounds of the general formula

$$R\text{ - }(O\text{ - }CH_2\text{ - }CH_2\text{ -})_n\text{ - }O\text{ - }R$$

where
$R$ denotes $C_mH_{2m+1}$,
$n$ denotes an integer from 1 to 25 and
$m$ denotes an integer from 1 to 5,
and in that the water content of the developer does not exceed 20 % by weight.

2. The process as claimed in Claim 1, wherein the diazonium salt polycondensation product comprises recurrent $A\text{-}N_2X$ and B units which are mutually linked by bridge members, especially methylene groups, which are derived from carbonyl compounds capable of condensation, A being the radical of an aromatic diazonium compound capable of condensation with formaldehyde, and B being the radical of a compound which is free of diazonium groups and is capable of condensation with formaldehyde, particularly of an aromatic amine, a phenol, a phenol ether, an aromatic thioether, an aromatic hydrocarbon, an aromatic heterocyclic compound or an organic acid amide.

3. The process as claimed in Claim 1 or 2, wherein the developer is comprised of a mixture of compounds corresponding to the general formula.

4. The process as claimed in any of Claims 1 to 3, wherein the developer additionally contains surfactants.

5. The process as claimed in Claim 4, wherein the admixture amounts to not more than 15 % by weight.

6. The process as claimed in any of Claims 1 to 5, wherein the developer additionally contains alcohols.

7. The process as claimed in Claim 6, wherein the admixture amounts to not more than 5 to 40 % by weight.

8. The process as claimed in any of Claims 1 to 7, wherein the developer additionally contains N,N-dimethylacetamide, N-methylpyrrolidone, N-hexylpyrrolidone, N,N-dimethylformamide, dimethylsulfoxide, butyrolactone or aliphatic hydrocarbons.

9. The process as claimed in Claim 8, wherein the admixture amounts to not more than 50 % by weight.

## Revendications

1. Procédé pour le développement de plaques offset imprimant à sec, qui portent, sur un support de couches, une couche photosensible à base d'un produit de polycondensation de sel de diazonium et une couche sus-jacente de caoutchouc silicone réticulé repoussant l'encre d'imprimerie, caractérisé en ce que le révélateur contient principalement des composés de formule générale
$$R\text{-}(O\text{-}CH_2\text{-}CH_2\text{-})_n\text{-}O\text{-}R$$
dans laquelle
$R = C_mH_{2m+1}$,
n représente un nombre allant de 1 à 25 et
m représente un nombre allant de 1 à 5,
et la teneur en eau du révélateur est au maximum de 20 % en poids.

2. Procédé selon la revendication 1, caractérisé en ce que le produit de polycondensation de sel de diazonium est constitué de motifs répétitifs $A\text{-}N_2X$ et B qui sont liés les uns aux autres par des chaînons intermédiaires, de préférence des groupes méthylène, qui sont dérivés de composés carbonyle condensables, A étant le reste d'un composé diazonium aromatique condensable avec le formaldéhyde, et B étant le reste d'un composé exempt de groupes diazonium et condensable avec le formaldéhyde, en particulier d'une amine aromatique, d'un phénol, d'un phénoléther, d'un thioéther aromatique, d'un hydrocarbure aromatique ou d'un amide organique.

3. Procédé selon la revendication 1 ou 2, caractérisé en ce que le révélateur. est constitué de mélanges des composés conformes à la formule générale.

4. Procédé selon l'une des revendications 1 à 3, caractérisé en ce que le révélateur contient en outre des tensioactifs.

5. Procédé selon la revendication 4, caractérisé en ce que l'addition est au maximum de 15 % en poids.

6. Procédé selon l'une des revendications 1 à 5, caractérisé en ce que le révélateur contient en outre des alcools.

7. Procédé selon la revendication 6, caractérisé en ce que l'addition est au maximum de 5 à 40 % en poids.

8. Procédé selon l'une des revendications 1 à 7, caractérisé en ce que le révélateur contient en outre du N,N-diméthylacétamide, de la N-méthylpyrrolidone, de la N-hexylpyrrolidone, du N,N-diméthylformamide, du diméthylsulfoxyde, de la butyrolactone ou des hydrocarbures aliphatiques.

9. Procédé selon la revendication 8, caractérisé en ce que la teneur est au maximum de 50 % en poids.